(19) Europäisches Patentamt
European Patent Office
Office européen des brevets

(11) Publication number: **0 465 727 A1**

(12) **EUROPEAN PATENT APPLICATION**

(21) Application number: **90201775.5**

(51) Int. Cl.⁵: **B41M 5/38**, G03F 1/00

(22) Date of filing: **03.07.90**

(43) Date of publication of application:
**15.01.92 Bulletin 92/03**

(84) Designated Contracting States:
**AT BE CH DE DK ES FR GB GR LI LU NL SE**

(71) Applicant: **AGFA-GEVAERT naamloze vennootschap**
**Septestraat 27**
**B-2510 Mortsel(BE)**

(72) Inventor: **De Brabandere, Luc Achiel**
**Zevenbergen 52**
**B-2500 Lier(BE)**
Inventor: **Janssens, Wilhelmus**
**De Egdstraat 11**
**B-3201 Langdorp(BE)**
Inventor: **Vanmaele, Luc Jerome**
**Dorpsstraat 52**
**B-9080 Lochristi(BE)**

(54) **Process for the production of linework and/or halftone pattern.**

(57) A process for the production of a linework and/or halftone pattern comprising the steps of :
(1) forming without wet processing an ultraviolet radiation (UV) absorbing line work and/or halftone mask by transferring at least one ultraviolet absorbing compound from a heat-sensitive recording layer onto an UV-transparent image receiving material, said transfer proceeding by pixelwise heating said recording layer to make the ultraviolet absorbing compound(s) form in the image-receiving material a pixel density of at least 2 in the spectral range of 300 to 450 nm, and
(2) contact-exposing an UV-radiation sensitive imaging material through said mask to obtain in said imaging material a detectable change in chemical or physical properties.

EP 0 465 727 A1

1. Field of the invention

This invention relates to a process for the production of halftone or linework patterns by means of ultraviolet sensitive recording materials using in their exposure a thermally obtained mask of ultraviolet absorbing material.

2. Background of the invention

The production of a pattern of silver and ultra-violet absorbing compounds serving as a mask for reproduction on ultra-violet radiation sensitive polymeric resist materials, e.g. used for lithographic plate making or for printed circuit or integrated circuit production is described in Research Disclosure March 1983, item 22711 and in published European Patent Application 0 260 349. In the described process a pattern of silver and ultra-violet absorbing substances is formed by means of a silver halide emulsion material being a modified dye diffusion transfer material in that the transferable dye moiety is a substance mainly absorbing electromagnetic radiation of the ultraviolet spectrum range (300 to 450 nm range). After the image-wise exposure and processing a residual image of ultra-violet absorbing substances together with a developed silver image is left in the photographic material, which image is called therefore "retained image".

The production of such retained image requires a wet processing and mostly yields an image wherein the background, i.e. the non-exposed areas, still contain ultra-violet absorbing substances that are not extracted from said areas and built an unwanted background density.

According to a more recent technique dye images are produced by thermal-dye transfer printing, e.g. by selectively energizing the electrical resistors of a thermal head array in contact with a thin thermally stable resin base, which contains on its opposite side a so-called dye-layer from which a dye can be thermally transferred onto a receptor material.

According to another technique known as resistive ribbon non-impact printing [ref. e.g. Progress in Basic Principles of Imaging Systems - Proceedings of the International Congress of Photographic Science Köln (Cologne), 1986, editors : Friedrich Granzer and Erik Moisar, Friedr. Vieweg & Sohn - Braunschweig/Wiesbaden, Journal of Imaging Technology, Vol. 12, No. 2, April 1986, p. 100-110 and Journal of Imaging Science - Volume 33, No. 1, January/February 1989, p. 7) from an electrode-array electrical current is sent pixelwise into a resistive ribbon coated with a thermally transferable dye. According to an embodiment the resistive ribbon consits of a 16 um composite film of polycarbonate imbedded with electrically conductive carbon black and has a sheet resistance in the range of 500 to 900 ohms/square. The carbon loaded polycarbonate base is overcoated with a thin layer (100 nm) of aluminium having a naturally formed oxide layer of about 4 nm. On said aluminium layer a thermal dye transfer coating is applied which during printing is kept in contact with a paper sheet acting as dye receptor material. The interface resistance of the aluminium serves additionally to Joule heating which mainly occurs in the carbon loaded polycarbonate base and stems from a current pulse injected from a pixel-electrode that makes contact with said base.

According to still another technique known as laser-induced thermal dye transfer (ref. e.g. US-P 4,876,235) a dye donor element is used which contains a thermally transferable dye and a finely divided substance that is heated by absorbing laser light. According to a particular embodiment an infrared emitting laser and a dye-donor element containing an infrared absorbing material is used as described e.g. in US-P 4,912,083.

In said dry dye transfer processes heat is supplied pixelwise by modulated laser beam, energized electrodes or resistors. The image signals for modulating the laser beam or electrode energy are obtained directly e.g. from opto-electronic scanning devices or from an intermediary storage means, e.g. magnetic disc or tape or optical disc storage medium, optionally linked to a digital image work station wherein the image information can be processed to satisfy particular needs.

According to a recently disclosed technique, see e.g. US-P 4,908,631, an ultrasonic pixel printer is applied to a dye donor layer to cause the dye to melt and/or sublime and transfer to a receiver.

Thermal dye transfer processes are intended mainly for multicolour dye image reproduction but are not restricted to the transfer of substances absorbing in the visible spectrum. For example, said processes are applied likewise in thermal transfer of fluorescent compounds as described e.g. in US-P 4,876,234, 4,876,234 and 4,891,351. These fluorescent compounds are used to obtain visible fluorescent light images by their exposure to ultraviolet light. Under normal viewing conditions the pattern of fluorescent compounds is invisible and may serve to include in documents such as ID-cards invisible confidential information that only by UV-exposure can be made visible.

## 3. Summary of the invention

It is an object of the present invention to provide a process for the production of a linework and/or halftone pattern in a recording material sensitive to ultraviolet radiation (UV) by exposing said material with said radiation through a UV absorbing mask that has been formed pixelwise without having been involved in a wet development step.

It is a further object of the present invention to use said process e.g. in the production of lithographic printing plates, colour proofs, electrostatic printing masters, and printed circuit boards.

Other objects and advantages of the present invention will become clear from the following description and examples.

According to the present invention a process for the production of a linework and/or halftone pattern comprises the steps of :

(1) forming without wet processing an ultraviolet radiation (UV) absorbing line work and/or halftone mask by transferring at least one ultraviolet absorbing compound from a heat-sensitive recording layer onto an UV-transparent image receiving material, said transfer proceeding by pixelwise heating said recording layer to make the ultraviolet absorbing compound(s) form in the image-receiving material a pixel density of at least 2 in the spectral range of 300 to 450 nm, and

(2) contact-exposing an UV-radiation sensitive imaging material through said mask to obtain in said imaging material a detectable change in chemical or physical properties.

"UV" stands for ultraviolet radiation.

A "pixel" is a picture element; minimum raster display element, represented as a point with a specified color or intensity level", which definition is quoted from "Computer Graphic Networks - Guidelines for Professional Computing, Office Automation, Graphic Arts and Media, March, 1985 - Printing Industries of America, Inc. Computer Technologies Department, 1730 North Lynn Street - Arlington, Virginia 22209, USA.

By "detectable change in chemical properties" is meant that by chemical reaction the change in the UV-exposed areas of the imaging material used in said step (2) can be made visible, e.g. the reducibility of UV-exposed compounds in said imaging material is increased selectively as is the case e.g. for UV-exposed silver halide salts which become chemically selectively reducible by an alkaline developer liquid.

By "detectable change in physical properties" is meant that the change in physical properties of said imaging material in the UV-exposed areas with respect to the UV non-exposed areas of the imaging material are useful for visible image production. Such change is e.g. a change in:

(1) opacity or transparency to visible light,
(2) adhesion power towards powder particles or a stripping layer,
(3) mechanical strength or cohesion,
(4) permeability to water or aqueous liquids,
(5) wettability with respect to aqueous or oleophilic liquids,
(6) dissolvability by wash-off liquid, or
(7) electrical conductivity and reciprocally electrical resistance.

An imagewise change in wettability makes it possible e.g. to produce a planographic (lithographic) printing master. A change in adhesion power or dissolvability makes it possible to produce a colour proof according to known principles. A change in electrical conductivity reciprocally electrical resistance makes it possible to produce an electrostatic master by corona charging an imaging material having a pattern of electrical resistance in an electrically conductive background.

## 4. Detailed description of the invention

In the production of an ultraviolet radiation (UV) absorbing mask any UV-absorbing compound can be used that is transferable by heat either or not in the presence of a low melting binding agent e.g. low molecular thermoplastic polymer or wax (ref. e.g. the already mentioned Proceedings of the International Congress of Photographic Science Köln).

In thermal transfer proceeding without softened or molten binding agent the applied UV-absorbing compound is of the kind that by heating is transformed into vapour and can deposit has a sublimate onto the image receiving material or is transformed into liquid, optionally in the presence of a thermal solvent, and diffuses from the donor material onto the image-receiving material.

The distinction between what is called in prior art "thermal dye sublimation" and "thermal dye diffusion by melting" is not always very sharp and both terminologies are used simply to define thermal transfer of dye without accompanying binder.

One type of donor element for use in thermal transfer of an UV-absorbing compound by contact-heating

through the back of the recording element comprises a very thin support, e.g. polyester resin support having a thickness in the range of 2 to 10 µm one side of which is covered with a binder layer from which the UV-absorbing compound can leave when heated to obtain sufficient vapour pressure or fluidity (diffusion mobility) optionally together with a molten thermal solvent. Usually an adhesive or subbing layer is provided between the support and the layer containing the UV-absorbing compound. Normally the opposite side is covered with a slipping layer that provides a lubricated surface against which the thermal printing head can pass without suffering abrasion. An adhesive layer may be provided between the support and the slipping layer.

Another type of donor element suited for laser-induced thermal transfer of an UV-absorbing compound comprises a support having thereon a layer containing a UV-absorbing compound that can be melted or vapourized by the heat produced in a laser light absorbing substance making thermal contact with the UV-absorbing compound. For example, when using an infra-red light emitting laser source the donor element contains a thermally transferable UV-absorbing compound in a binder in admixture with an infra-red absorbing compound, e.g. as described in US-P 2,503,759, 4,788,128, US-P 4,912,083, published UK Patent Application 2 083 726, published European Patent Application (EP-A) 0 282 181 or 0 282 182.

Laser writing wherein laser energy is used to irradiate the uncoated surface of a thin film element, coated on one surface with an ink-like coating to cause selective transfer of the coating to an adjacently spaced material has been described already in US-P 3,745,586.

In Journal of Applied Photographic Engineering, Vol. 3, No. 1 Winter 1977, C.A. Bruce and J.T. Jacobs have published an article on : "Laser Transfer of Volatile Dyes" giving details on ribbon preparation and the laser printing station. The laser light absorber used is carbon black and the applied laserlight stems from a He-Ne laser emitting at 633 nm.

As described e.g. in US-P 4,772,582 spacer beads may be coated over a dye donor-layer which according to the present invention provides UV-absorbing compound(s) thereby increasing the uniformity and density of the transfer of the UV-absorbing compound(s). The spacer beads may be coated with a polymeric binder. Optionally the image receiving element contains spacer beads as described e.g. in US-P 4,876,235.

According to a preferred embodiment of the process of the present invention in step (1) a donor element for thermal transfer is heated imagewise in contact with a receptor element to transfer thereon a UV-absorbing compound, said donor element comprising a sheet, ribbon or web support having on one side thereof a layer incorporating in a wax or polymeric binder material an UV-absorbing benzthiazole compound corresponding to the following general formula (A):

(A) 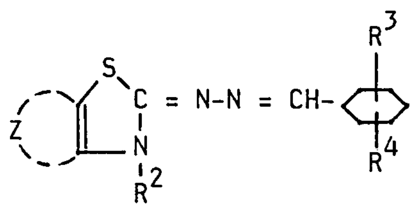

wherein :

Z represents the atoms necessary to close an unsubstituted or substituted adjacent aromatic ring or ringsystem, e.g. an adjacent benzene ring either or not substituted with one or more substituents $R^1$ of the following group : alkyl, e.g. methyl, alkoxy, halogen, e.g. chlorine or bromine, and cyano, -COR, $-SO_2R$, -NHCOR, or $-NHSO_2R$, wherein R is alkyl, alkaryl or aryl; $-SO_2-N(R^{11},R^{12})$, wherein each of $R^{11}$ and $R^{12}$ (same or different) is hydrogen, alkyl, alkaryl or aryl, and $-NHP(O)(R^{13},R^{14})$,wherein each of $R^{13}$ and $R^{14}$ - (same or different) is hydrogen, alkyl, alkaryl, aryl, alkoxy, amino or substituted amino, e.g. dialkylamino, $R^2$ represents hydrogen, an alkyl group of 1 to 4 carbon atoms, or an aryl group, e.g. phenyl group,

each of $R^3$ and $R^4$ (same or different) represents hydrogen, an amino group, a substituted amino group, e.g. a dialkylamino group, an alkoxy group or a substituted alkoxy group.

The preparation of compounds according to the above general formula (A) proceeds e.g. as described in US-P 3,745,010.

Specific examples of UV-absorbing compounds that are fusible and thermally transferable by diffusion out of a binder layer are listed in the following Table 1 with their absorption maximum (AM) expressed in nm, extinction coefficient ($\epsilon$) expressed in $cm^{-1}.mol^{-1}/l$ and melting point expressed in centigrades (°C).

TABLE 1

| No. | Structural formula | AM nm | $\varepsilon$ | MP °C |
|---|---|---|---|---|
| 1. | 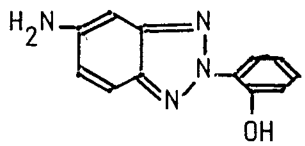 | 211<br>362 | 29401 | 213 |
| 2. | 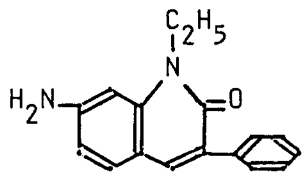 | 228<br>365 | - | 171 |
| 3. | 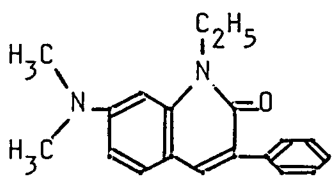 | 233<br>370 | 43575 | 115 |
| 4. | 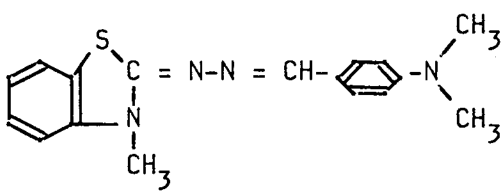 | 367 | 50629 | 170 |
| 5. | 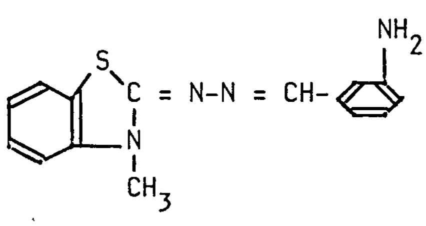 | 237<br>350 | 30620 | 169 |
| 6. | 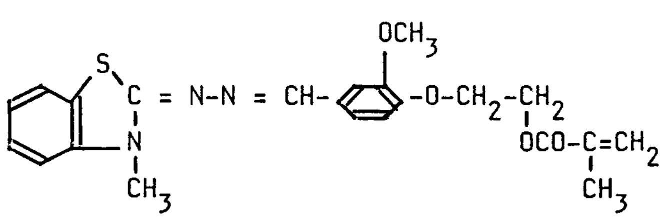 | 351 | 37323 | 134 |

| | | | | |
|---|---|---|---|---|
| 7. | 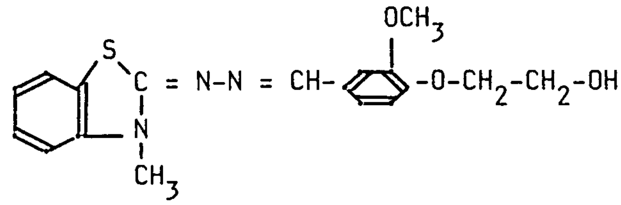 | 351 | 36122 | 190 |
| 8. | 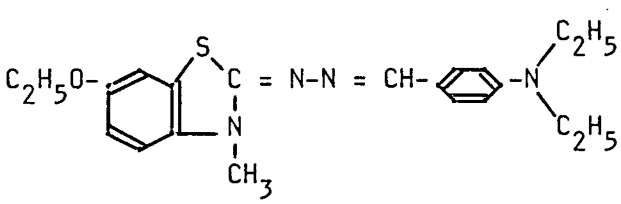 | 372 | 51951 | 123 |

The above compounds 1 to 3 are commercially available. The compounds 4 to 8 were prepared as described in US-P 3,745,010 according to which said compounds are used as starting materials in the preparation of UV-absorbing polymers for use in photographic elements.

Together with the UV-absorbing compound(s) any dye or mixture of dyes absorbing in the visible spectrum may be transferred thermally. Such allows to make a visual check on the quality of the the thermally transferred image. A black dye image may be obtained as described e.g. in US-P 4,816,435 and unpublished EP-A 90200991.9.

The heat-sensitive recording material suited for heat-induced (thermal) transfer of the UV-absorbing compound(s) is formed preferably by adding the UV-absorbing compound(s), the polymeric binder medium, and other optional components to a suitable solvent or solvent mixture, dissolving or dispersing the ingredients to form a coating composition that is applied to a support, which may have been provided first with an adhesive or subbing layer, and dried.

The thickness of the donor-layer is about 0.2 to 5.0 µm, preferably 0.4 to 2.0 µm, and the amount ratio of UV-absorbing compound to binder is between 9:1 and 1:3 by weight, preferably between 2:1 and 1:2 by weight.

As polymeric binder the following can be used: cellulose derivatives, such as ethyl cellulose, hydroxyethyl cellulose, ethylhydroxy cellulose, ethylhydroxyethyl cellulose, hydroxypropyl cellulose, methyl cellulose, nitrocellulose, cellulose acetate formate, cellulose acetate hydrogen phthalate, cellulose acetate, cellulose acetate propionate, cellulose acetate butyrate, cellulose acetate pentanoate, cellulose acetate benzoate, cellulose triacetate; vinyl-type resins and derivatives, such as polyvinyl alcohol, polyvinyl acetate, polyvinyl butyral, copolyvinyl butyral-vinyl acetal-vinyl alcohol, polyvinyl pyrrolidone, polyvinyl acetoacetal, polyacrylamide; polymers and copolymers derived from acrylates and acrylate derivatives, such as polyacrylic acid, polymethyl methacrylate and styrene-acrylate copolymers; polyester resins; polycarbonates; copolystyrene-acrylonitrile; polysulfones; polyphenylene oxide; organosilicones, such as polysiloxanes; epoxy resins and natural resins, such as gum arabic, and likewise modified natural binders such as modified dextrans described in unpublished European Patent Application No. 90200481.1.

The thermal transfer of the UV-absorbing compound may be improved by its use in conjunction with a thermal solvent. Thermal solvents are non-hydrolyzable organic compounds that are solid at ambient temperature (20-25 °C) but liquid at elevated temperature. Preferably they have a melting point between 40 °C and 300 °C, more preferably between 40 and 150 °C. In fused state they act as a solvent for the UV-absorbing compound(s) to be transferred. Examples of thermal solvents have been described in US-P 3,347,675, 3,438,776, 3,667,959 and 4,740,446, published EP-A 0 119 615 and 0 122 512 and DE-A 3 339 810. Further such solvents are described in Research Disclosure (December 1976), item 15027 for use in photothermographic methods and materials containing light sensitive silver salts.

The donor element containing the UV-absorbing compound(s) may comprise other additives, such as curing agents, preservatives, etc. These and other ingredients are described e.g. in EP 133011, EP 133012, EP 111004 and EP 279467.

Any material can be used as the support for the UV-absorbing compound provided it is dimensionally stable and capable of withstanding the temperatures involved, up to 400 °C over a period of up to 20 msec, and is yet thin enough to transmit heat applied on one side through to the dye on the other side to effect transfer to the receiver sheet within such short periods, typically from 1 to 10 msec. Such materials include polyesters such as polyethylene terephthalate, polyamides, polyacrylates, polycarbonates, cellulose esters,

fluorinated polymers, polyethers, polyacetals, polyolefins, polyimides, glassine paper and condenser paper. Preference is given to a support comprising polyethylene terephthalate. In general, the support has a thickness of 2 to 30 µm. The support may also be coated with an adhesive or subbing layer, if desired.

The donor layer containing the UV-absorbing compound may be coated on the support or printed thereon by a printing technique such as a gravure process.

A barrier layer comprising a hydrophilic polymer may also be employed in the donor element between its support and the layer containing the UV-absorbing compound to improve transfer densities by preventing wrong-way transfer of UV-absorbing compound towards the support. In general, good results have been obtained with a barrier layer on the basis of gelatin, polyacryl amide, polyisopropyl acrylamide, butyl methacrylate grafted gelatin, ethyl methacrylate grafted gelatin, ethyl acrylate grafted gelatin, cellulose monoacetate, methyl cellulose, polyvinyl alcohol, polyethylene imine, polyacrylic acid, a mixture of polyvinyl alcohol and polyvinyl acetate, a mixture of polyvinyl alcohol and polyacrylic acid or a mixture of cellulose monoacetate and polyacrylic acid. Suitable barrier layers have been described in e.g. EP 227091 and EP 228065. Certain hydrophilic polymers, for example those described in EP 227091, also have an adequate adhesion to the support and the donor layer thermally transferring a UV-absorbing compound, thus eliminating the need for a separate adhesive or subbing layer. These particular hydrophilic polymers used in a single layer in the donor element thus perform a dual function, hence are referred to as barrier/subbing layers.

Preferably the reverse side of the donor element can be coated with a slipping layer to prevent the printing head from sticking to the dye-donor element. Such a slipping layer would comprise a lubricating material such as a surface active agent, a liquid lubricant, a solid lubricant or mixtures thereof, with or without a polymeric binder. The surface active agents may be any agents known in the art such as carboxylates, sulfonates, phosphates, aliphatic amine salts, aliphatic quaternary ammonium salts, polyoxyethylene alkyl ethers, polyethylene glycol fatty acid esters, fluoroalkyl $C_2$-$C_{20}$ aliphatic acids. Examples of liquid lubricants include silicone oils, synthetic oils, saturated hydrocarbons and glycols. Examples of solid lubricants include various higher alcohols such as stearyl alcohol, fatty acids and fatty acid esters. Suitable slipping layers are described in e.g. EP 138483, EP 227090, US 4567113, US 4572860, US 4717711. Preferably the slipping layer comprises as binder a styrene-acrylonitrile copolymer or a styrene-acrylonitrile-butadiene copolymer or a mixture hereof and as lubricant in an amount of 0.1 to 10 % by weight of the binder (mixture) a polysiloxane-polyether copolymer or polytetrafluoroethylene or a mixture hereof.

The support of the image-receiving layer that is used in conjunction with the donor element providing the UV-absorbing compound is for use in the contact exposure in transmission according to step (2) of the process according to the present invention a transparent base, e.g. a resin base made of polyethylene terephthalate, a polyether sulfone, a polyimide, a cellulose ester or a polyvinyl alcohol-co-acetal. The image-receiving layer capturing the UV-absorbing compound(s) may comprise, for example, a polycarbonate, a polyurethane, a polyester, a polyamide, polyvinyl chloride, polystyrene-co-acrylonitrile, polycaprolactone or mixtures thereof. Suitable image-receiving layers have been described in e.g. EP 133011, EP 133012, EP 144247, EP 227094, EP 228066 and in unpublished European Patent Application No. 90200481.1.

The UV-compound providing donor element or the therewith associated image-receiving layer of the receiver sheet may also contain a releasing agent that aids in separating the donor element from the image-receiving element after transfer. The releasing agents can also be applied in a separate layer on at least part of the UV-absorbing compound donor layer or of the image-receiving layer. For the releasing agent solid waxes, fluorine- or phosphate-containing surfactants and silicone oils are used. Suitable releasing agents are described in e.g. EP 133012, JP 85/19138, EP 227092.

According to an embodiment operating with contact heating using a thermal head in the form of pixelwise electrically heated resistor elements the donor layer providing the UV-absorbing compound is placed in face-to-face relation with the image-receiving layer of the receiver element and imagewise heating proceeds from the back of the donor element. The transfer of the UV-absorbing compound is accomplished by heating for about several milliseconds at a temperature of 400 °C. Thermal printing heads that can be used for thermal dye transfer and that are equally well applicable in the thermal transfer of UV-absorbing compounds in the process of the present invention are commercially available.

In a particular embodiment of contact heating the support of the donor element providing the UV-absorbing compound is an electrically resistive ribbon consisting of, for example, a multi-layer structure of a carbon loaded polycarbonate coated with a thin aluminum film. Current is injected with pulses into the resistive ribbon by electrically adressing a print head electrode resulting in highly localized heating of the ribbon beneath the relevant electrode. An advantage of printing speed is obtained by using the resistive ribbon/electrode head technology compared to the thermal head technology where the various elements of the thermal head get hot and must cool down before the head can move to the next printing position.

As an alternative to thermal head or resistive ribbon heating laser light can be used as the heat source for supplying heat energy. In case laser light is used, the donor layer providing the UV-absorbing compound(s) or a layer in heat-conductive relationship therewith has to contain a compound that absorbs the light emitted by the laser and converts it into heat, e.g. carbon black.

The process of the present invention is particularly suited for the production of lithographic printing plates, colour proofs and electrostatic printing masters with recording materials that are UV-sensitive and are contact-exposed in step (2) through the UV-absorbing mask obtained in step (1).

In lithographic platemaking mostly presensitized metal plates are used which originally were zinc plates coated with bichromated albumin or bichromated casein. These plates are now obsolete and have been replaced by diazo presensitized and wipe-on plates which are used for runs up to 75,000 impressions. Diazo presensitized and coated wipe-on plates are easy to process. After exposure to negatives (masks) they are treated with a developer which consists of a lacquer and a gum etch in acid solution. As the unexposed diazo is dissolved by the acidified gum, the gum deposits on the non-printing developed areas ensuring their water receptivity and lacquer deposits on the exposed areas ensuring the acceptance of oil-type printing ink.

Other lithographic plates are of the photopolymer type most of which are likewise exposed through negatives. Plates of the organic soluble type are made e.g. with cinnamic esters of epoxy resins that offer a better abrasion resistance than the above wipe-on plates.

Lithographic printing plates can be produced likewise by the silver complex diffusion transfer process as described e.g. in US-P 4,824,760.

Since most of the lithography is done by the offset process, the plates must be straight reading. However, in order to avoid light undercutting of the lines or screen dots, the masks used in the contact exposure of the lithographic plate must be reverse reading having the imaged side in contact with the UV-sensitive layer of the lithographic plate during its UV-exposure. The electronic addressing of a thermal head or the modulation system of a laser beam to obtain a reverse image poses no problem in signal manipulation, so that the present step (1) can yield easily a reverse reading mask.

In lithography applied for multicolour printing different lithographic printing plates are prepared, one for each primary colour of the multicolour original and printing on the final printing stock proceeds in image register according to the principles of subtractive colour reproduction with a cyan, magenta, yellow and optionally black printing ink.

In order to avoid proof press printing which entails the preparation of actual printing plates for the generation of ink impression prints, colour-proofing materials provide means for the control of the quality of the colour separations and yield a colour image that is suficiently faithful to replace the ones of a printing run.

A great deal of presently available colour-proofing materials comprise a carrier sheet and a layer coated thereon of a photographic material which reacts to light exposure in such a manner that it exhibits a greater or lesser degree of solubility in developing fluids. Typical examples of such materials are described in US-P 3,326,682, 3,527,604, 3,642,474, and 4,376,158. The colour-proofing sheets utilizing these compositions generally comprise a layer of the photoresist material in which is incorporated pigment particles having the colour used in commercial printing inks for multicolour printing in registry.

Other colour-proofing materials, called post-coloured proofing materials, make it possible to prepare colour proofs of varying colour hue and intensity by means of a photopolymer layer which becomes less tacky in the light struck areas and selectively fixes an applied finely-divided pigment powder to the still highly tacky non-exposed areas. Such colour proofing material is descibed e.g. in US-P 3,060,024.

Practically all photopolymer compositions used in colour proofing are UV-sensitive.

The wash-off colour proofing materials based on the hardening development of a photosensitive silver halide emulsion layer can obtain a controlled photosensitivity that allows their imaging exposure with ultra-violet radiation without causing fog by ambient room light illumination. The silver halide emulsion layers can be of the negative working type or are direct positive emulsions as described e.g. in US-P 4,701,401.

The electronic digital signals obtained by scanning a multicolour original can be used to produce the necessary UV-masks serving as colour separations for exposing therethrough e.g. the photo-resist materials for forming the monochrome lithographic printing plated and/or the UV-sensitive recording materials used in colour proofing.

According to a particular embodiment the contact exposure of step (2) for the production of a lithographic (planographic) printing master is preceded by the production of a colour proof by thermal dye transfer using the same digital image information as applied in the production of the printing master. Such colour proof can be obtained by thermal printing with a commercially available multicolour field dye transfer ribbon, an example of which is described in Fig. 1 of published EP-A 0 357 363.

Photoresist polymers find a broad application in the production of electronic circuitry, e.g. printed circuits and microcircuits. Photoresists may be negative or positive. The negative photoresists increase in molecular weight by photopolymerization or crosslinking in the exposed areas, and thereby the exposed portions become less soluble in suitable developing liquids. Positive photoresists are degraded by irradiation and a decrease in molecular weight is accompanied by increased solubility of the exposed areas in the developer. Examples of polymeric resist materials of said both types are described in Journal of Applied Photographic Engineering, Volume 7, Number 2, April 1981, p. 37-44.

Another very interesting field for the use of photopolymers is in the production of an electrostatic printing master for xeroprinting. The basics and examples for such production are published by E. Inoue and F. Fukutomi in the Journal of the Society for Photographic Science and Technics, Japan, 41 (1978) No. 5, p. 333-340 and in US-P 4,732,831. According to the latter US-P document xeroprinting comprises the steps :

(1) imagewise exposing to actinic radiation an electrostatic master having a photopolymerizable conductive film to selectively polymerize and thereby increase resistance in exposed areas of the film;
(2) charging the master by corona discharge while on a conductive support to form a latent image of electrostatic charge on the exposed areas;
(3) developing the image by applying an oppositely charged electrostatic toner; and
(4) transferring the toner image to another surface.

According to another technique a conductivity pattern corresponding with an UV-exposed area in a background area of non-exposed electrically insulating material is obtained by the production of a silver image in an electrically insulating binder as described e.g. in US-P 4,069,759, EP-A 0 243 935 and GB-P 1 522 641 and 1 522 642.

The toner development may be a reversal development as described e.g. in unpublished EP-A 89202664.2.

In agreement with the present invention the imaging exposure of the above defined UV-sensitive recording materials proceeds through the mask obtained in step (1) of the process of the summary of the invention.

So, the present process is advantageously used for the production of a lithographic (planographic) printing master, colour proof, xeroprinting master or electronic circuitry print, e.g. printed circuit board.

The following examples illustrate the present invention without however limiting it thereto.

All ratios and percentages are by weight unless otherwise indicated.

EXAMPLE 1

A series of thermal imaging donor elements for forming an UV-absorbing mask in an image-receiving material were prepared.

Therefor a particular amount of binder as identified below and of an UV-absorbing compound (UVC) of Table 1 were dissolved in methyl ethyl keton (mg per 10 ml) as indicated in Table 2 and coated at a coverage of 0.5 g/m2 of UV-absorbing compound on a 6 $\mu$m thick polyethylene terephthalate film. The resulting layer was dried by evaporation of the solvent. Optionally to the coating composition 1,10-decanediol as thermal solvent was added to be coated at a coverage of 300 mg/m$^2$.

The above prepared donor element was used in combination with a commercially available transparent film-type image-receiving material (MITSUBISHI CK100TS) to receive the thermally transferred UV-absorbing compound.

The thermal transfer printing proceeded in a MITSUBISHI CP100E color video printer using the electronic digital information obtained from the monochrome scanning (succesively red, green and blue) of a multicolour original intended for reproduction by lithographic printing.

The receiver sheet was separated from the dye-donor element and the UV-density measured with a MACBETH Quanta Log (registered trade mark) densitometer using a KODAK Wratten filter 18A to cut off visible light.

The measured maximum density value ($D_{max}$) corresponding with pixel density is listed in the following Table 2. A pixel density of at least 2 is required for a good graphic art quality in halftone dot reproduction.

In said Table 2 binder B1 stands for nitrocellulose with a nitrogen content of 10% and B2 for cellulose acetate butyrate having an acetyl content of 29.5% and a butyryl content of 17%.

Table 2

| UV-compound | binder | mg UVC/ mg binder | TS | $D_{max}$ |
|---|---|---|---|---|
| 1 | B2 | 50/50 | none | 2.22 |
| 1 | B2 | 90/100 | none | 2.44 |
| 1 | B2 | 90/100 | present | 2.70 |
| 2 | B1 | 90/20 | none | 2.02 |
| 3 | B1 | 90/20 | none | 2.58 |
| 3 | B2 | 90/100 | none | 2.73 |
| 4 | B1 | 50/20 | none | 2.57 |
| 4 | B2 | 50/50 | none | 2.47 |
| 4 | B2 | 90/100 | present | 2.69 |
| 4 | B2 | 90/50 | present | 2.78 |
| 5 | B1 | 50/20 | none | 2.30 |

The obtained UV-masks corresponding with the red, green and blue separations of the multicolour original were used for UV-exposure in contact in vacuum frame of UV-sensitive colour proofing materials as described in US-P 3,642,474.

Said UV-masks yielding a satisfactory pre-press multicolour proof obtained by wash-off processing were further used in the contact exposure of different sheets of a UV sensitive photoresist material that is developed with pure water as described in US-P 4,812,384 to form the necessary planographic printing plates for multicour printing in register.

EXAMPLE 2

A visual check on the quality of UV-masks produced by thermal transfer has been made possible by using in the thermal transfer coating composition in admixture with a thermally transferable UV-compound a thermally transferable dye as identified hereinafter. The coating and thermal dye transfer proceeded as described in Example 1. In Table 3 the solid ingredients of the coating composition and their relative amounts are given. When used the thermal solvent TS of Example 1 was applied at a coverage of 250 mg/m2.

Table 3

| UV-compound | binder/TS | mg UVC/ mg dye(s)/ mg binder | Dye | $D_{max}$ | Image colour |
|---|---|---|---|---|---|
| 1 | B2/TS | 50/25/50 | D1 | 2.94 | yellow |
| 1 | B2/TS | 50/25/50 | D2 | 2.81 | orange-red |
| 3 | B2/-- | 90/30/10/100 | D1 & D3 | 2.96 | brown |

Structural formula of applied dye

D1 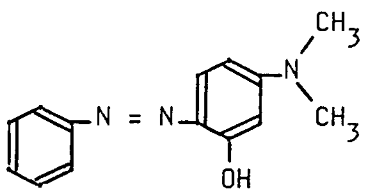

D2 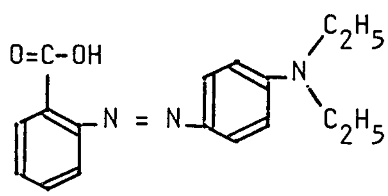

D3 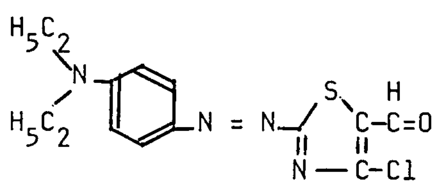

**Claims**

1. A process for the production of a linework and/or halftone pattern comprising the steps of :
(1) forming without wet processing an ultraviolet radiation (UV) absorbing line work and/or halftone mask by transferring at least one ultraviolet absorbing compound from a heat-sensitive recording layer onto an UV-transparent image receiving material, said transfer proceeding by pixelwise heating said recording layer to make the ultraviolet absorbing compound(s) form in the image-receiving material a pixel density of at least 2 in the spectral range of 300 to 450 nm, and
(2) contact-exposing an UV-radiation sensitive imaging material through said mask to obtain in said imaging material a detectable change in chemical or physical properties.

**2.** Process according to claim 1, wherein said UV-absorbing compound incorporated in a wax or polymeric binder material is present in said heat-sensitive recording layer on one side of a sheet, ribbon or web material and corresponds to the following general formula (A):

(A)

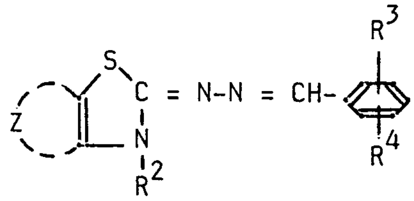

wherein :
Z represents the atoms necessary to close an unsubstituted or substituted adjacent aromatic ring or ringsystem,
$R^2$ represents hydrogen, an alkyl group of 1 to 4 carbon atoms, or an aryl group,
each of $R^3$ and $R^4$ (same or different) represents hydrogen, an amino group, a substituted amino group, an alkoxy group or a substituted alkoxy group.

**3.** A process according to claim 2, wherein Z represents the atoms necessary to close an adjacent benzene ring either or not substituted with one or more substituents $R^1$ of the following group : alkyl, e.g. methyl, alkoxy, halogen, e.g. chlorine or bromine, and cyano, -COR, $-SO_2R$, -NHCOR, or $-NHSO_2R$, wherein R is alkyl, alkaryl or aryl; $-SO_2-N(R^{11},R^{12})$, wherein each of $R^{11}$ and $R^{12}$ (same or different) is hydrogen, alkyl, alkaryl or aryl, and $-NHP(O)(R^{13},R^{14})$, wherein each of $R^{13}$ and $R^{14}$ (same or different) is hydrogen, alkyl, alkaryl, aryl, alkoxy, amino or substituted amino.

**4.** A process according to claim 2 or 3, wherein $R^2$ represents a methyl group.

**5.** A process according to claim 3, wherein $R^1$ represents an ethoxy group.

**6.** A process according to any of claims 1 to 5, wherein $R^3$ is hydrogen and $R^4$ is a dimethylamino or diethylamino group.

**7.** A process according to any of the preceding claims, wherein together with the UV-absorbing compound a dye or dyes is transferred onto the image-receiving material.

**8.** A process according to any of the preceding claims, wherein together with the UV-absorbing compound a thermal solvent is transferred onto the receptor element.

**9.** A process according to any of the preceding claims, wherein the imagewise heating proceeds with a thermal head comprising pixelwise heated resistor elements.

**10.** A process according to any of the claims 1 to 8, wherein the imagewise heating proceeds with a resistive ribbon structure wherein current is injected pulsewise.

**11.** A process according to any of claims 1 to 8, wherein the imagewise heating proceeds by imagewise modulated laser beam.

**12.** A process according to any of the preceding claims, wherein the detectable change in physical properties is a detectable change in one of the following properties :
(1) opacity or transparency to visible light,
(2) adhesion power towards powder particles or a stripping layer,
(3) mechanical strength or cohesion,
(4) permeability to water or aqueous liquids,
(5) wettability with respect to aqueous or oleophilic liquids,
(6) dissolvability by wash-off liquid, or
(7) electrical conductivity and reciprocally electrical resistance.

**13.** A process according to any of the preceding claims, wherein the contact exposure of step (2) is applied for the production of a lithographic (planographic) printing master, colour proof, xeroprinting master or electronic circuitry print.

**14.** A process according to any of the claims 1 to 12, wherein the contact exposure of step (2) being applied for the production of an ultra-violet radiation absorbing line work and/or halftone mask is preceded by the production of a colour proof by thermal dye transfer using the same digital image information as applied in the production of said mask.

European Patent Office

# EUROPEAN SEARCH REPORT

Application Number

**EP 90 20 1775**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | FR-A-1 355 880 (DITTO INC.)<br>* The whole document * | 1-14 | B 41 M 5/38<br>G 03 F 1/00 |
| A | PATENT ABSTRACTS OF JAPAN, vol. 12, no. 298 (P-744)[3145], 15th August 1988;<br>& JP-A-63 70 859 (TOYOTA AUTOMATIC LOOM WORKS LTD) 31-03-1988<br>* The whole document * | 1-14 | |
| A | PATENT ABSTRACTS OF JAPAN, vol. 4, no. 76 (M-14)[558], 3rd June 1980;<br>& JP-A-55 39 379 (MITSUBISHI DENKI K.K.) 19-03-1980<br>* The whole document * | 1-14 | |

TECHNICAL FIELDS SEARCHED (Int. Cl.5)

B 41 M
G 03 F

The present search report has been drawn up for all claims

| Place of search | Date of completion of search | Examiner |
|---|---|---|
| The Hague | 16 February 91 | BACON,A.J. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention
E : earlier patent document, but published on, or after the filing date
D : document cited in the application
L : document cited for other reasons
& : member of the same patent family, corresponding document